# FASCICULE DE BREVET EUROPEEN

(11) **EP 0 549 444 B1**
(45) Date de publication et mention de la délivrance du brevet: **16.08.1995**
(21) Numéro de dépôt: 92403483.8
(22) Date de dépôt: 21.12.1992
(51) Int. Cl.: G01V 3/10, H03K 17/693

(54) **Dispositif électronique de multiplexage de plusieurs charges excitées en courant alternatif**
Elektronische Vorrichtung zur Multiplexierung verschiedener mit Wechselstrom gespeisster Läste
Device for multiplexing several AC excited loads

(30) Priorité: 23.12.1991 FR 9116039
(43) Date de publication de la demande: 30.06.1993
(73) Titulaire: SEXTANT AVIONIQUE, F-92360 Meudon-la-Forêt (FR)
(72) Inventeur: Schou, Guy, F-92402 Courbevoie Cedex (FR); Verbeque, Jean-René, F-92402 Courbevoie Cedex (FR); Voisin, Gérard, F-92402 Courbevoie Cedex (FR)
(74) Mandataire: Beylot, Jacques

(56) Documents cités:
- DE-A- 2 020 573
- DE-A- 3 212 320
- FR-A- 1 553 967
- PATENT ABSTRACTS OF JAPAN, vol. 5, no. 191 (P-092) 5 Décembre 1981 & JP-A-56 117 178

## Description

La présente invention concerne l'excitation séquentielle de plusieurs charges à l'aide d'un courant alternatif.

Ce problème se pose notamment dans les systèmes électromagnétiques de repérage, à faible distance, de la position et de l'orientation d'un objet, tels que ceux utilisés pour repérer la position et l'orientation d'un casque porté par un pilote, par rapport à un trièdre de référence lié à la cabine de pilotage, afin de permettre le pilotage de certains instruments à l'aide des mouvements de la tête du pilote tout en lui laissant une parfaite liberté de mouvement.

Une manière de réaliser, par voie électromagnétique, un repérage, à faible distance, de la position et de l'orientation d'un objet consiste à émettre, en un point de repère, successivement selon les trois axes d'un trièdre de référence absolue, des champs électromagnétiques à basse fréquence de l'ordre de 10 KHz, à mesurer, selon les trois axes d'un trièdre de référence relative lié à l'objet dont on veut connaître la position et l'orientation, les composantes reçues des champs électromagnétiques successifs émis selon les trois axes du trièdre de référence absolue et à déduire de ces mesures et d'une cartographie préliminaire la position et l'orientation du trièdre de référence relative et donc de l'objet par rapport au trièdre de référence absolue. Cette manière de faire fonctionne d'autant mieux que l'on est capable d'engendrer des champs électromagnétiques successifs dans les directions précises des trois axes du trièdre de référence absolue c'est-à-dire que l'on est capable de bien découpler les émissions successives de ces trois champs électromagnétiques.

Les émissions successives de ces trois champs électromagnétiques se font à l'aide d'une antenne triple placée au point de repère et conformée en un cube à faces parallèles à celles du trièdre de référence absolue. Cette antenne triple est constituée de trois doubles enroulements orthogonaux disposés chacun selon deux faces parallèles du cube et dimensionnés de manière à engendrer, pour un même courant d'excitation, une même intensité de champ électromagnétique à l'extérieur du cube. La réception se fait à l'aide d'une antenne triple du même genre portée par l'objet dont on veut connaître la position et l'orientation, et conformée en cube dont les faces sont parallèles à celles du trièdre de référence relative.

L'antenne triple d'émission constitue pour l'émetteur une triple charge inductive ayant un certain nombre de spécificités.

Ses trois doubles enroulements développent à leurs bornes, lorsqu'ils sont parcourus par le courant d'excitation, une tension élevée qui atteint une centaine de volts renchérissant le coût d'un multiplexeur à transistors au cas où ces derniers auraient à supporter directement cette tension.

En outre, ces trois doubles enroulements ne sont pas identiques en raison des impératifs de bobinage selon les faces d'un cube et présentent des impédances différentes ce qui ne facilite pas le maintien d'une même intensité de courant d'excitation.

De plus, ces trois enroulements sont couplés par mutuelle inductance ce qui est propice aux courants de fuite.

La présente invention a pour but de lutter contre les difficultés précitées afin de réaliser, d'une manière simple et à faible coût, un multiplexage qui soit adapté aux spécificités d'une antenne triple d'émission d'un système électromagnétique de repérage, à faible distance, de la position et de l'orientation d'un objet.

Elle a pour objet un dispositif électronique de multiplexage de charges aux bornes d'une source d'énergie électrique alternative comportant :
- des moyens de couplage par flux électromagnétique de la source d'énergie électrique alternative aux charges comportant au moins un enroulement primaire d'excitation connecté aux bornes de la source d'énergie électrique alternative et des enroulements secondaires, en nombre égal à celui des charges, couplés au moins partiellement à l'enroulement primaire d'excitation et connectés chacun aux bornes d'une charge ;
- des moyens d'inhibition des moyens de couplage par flux électromagnétique comportant des enroulements auxiliaires, en nombre égal à celui des charges, chacun couplé totalement avec l'un des enroulements secondaires ; et
- des moyens de commande des moyens d'inhibition imposant l'inhibition de tous les couplages magnétiques sauf un qui change en fonction de la charge à connecter à la source d'énergie électrique alternative.

Les moyens de couplage par flux électromagnétique peuvent comporter un ou plusieurs enroulements primaires d'excitation. Lorsque l'enroulement primaire d'excitation est unique, il est couplé partiellement aux différents enroulements secondaires au sein d'un unique transformateur présentant un circuit magnétique avec plusieurs jambes parallèles, une première jambe autour de laquelle est bobiné l'enroulement primaire d'excitation et d'autres jambes autour de chacune desquelles sont bobinés à chaque fois un enroulement secondaire et un enroulement auxiliaire des moyens d'inhibition. Lorsque les moyens de couplage par flux électromagnétique comportent plusieurs enroulements primaires d'excitation, ceux-ci sont en nombre égal à celui des charges, connectés en série aux bornes de la source d'énergie électrique alternative et couplés chacun totalement avec un enroulement secondaire au sein d'un transformateur individuel qui comporte également un enroulement auxiliaire des moyens d'inhibition.

L'inhibition du coupage par flux électromagnétique s'obtient dans le cas de plusieurs enroulements primaires d'excitation avec des transformateurs distincts soit en mettant en court- circuit les enroulements auxiliaires soit en les faisant parcourir par un courant continu provoquant une saturation.

De manière avantageuse, le dispositif électronique de multiplexage comporte en outre des moyens interrupteur d'isolement, en nombre égal à celui des charges, intercalés chacun en série entre une charge et l'enroulement secondaire auquel elle est connectée, les moyens de commande imposant un état fermé au moyen interrupteur d'isolement disposé en série avec la charge dont le couplage par flux magnétique avec la source d'énergie électronique alternative n'est pas inhibé et un état ouvert à tous les autres moyens interrupteurs d'isolement.

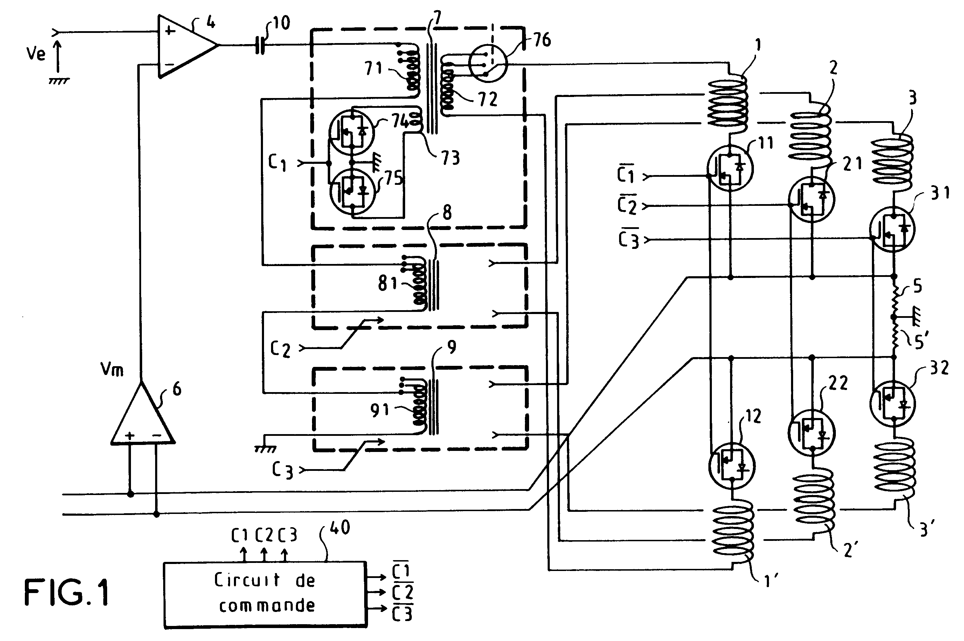

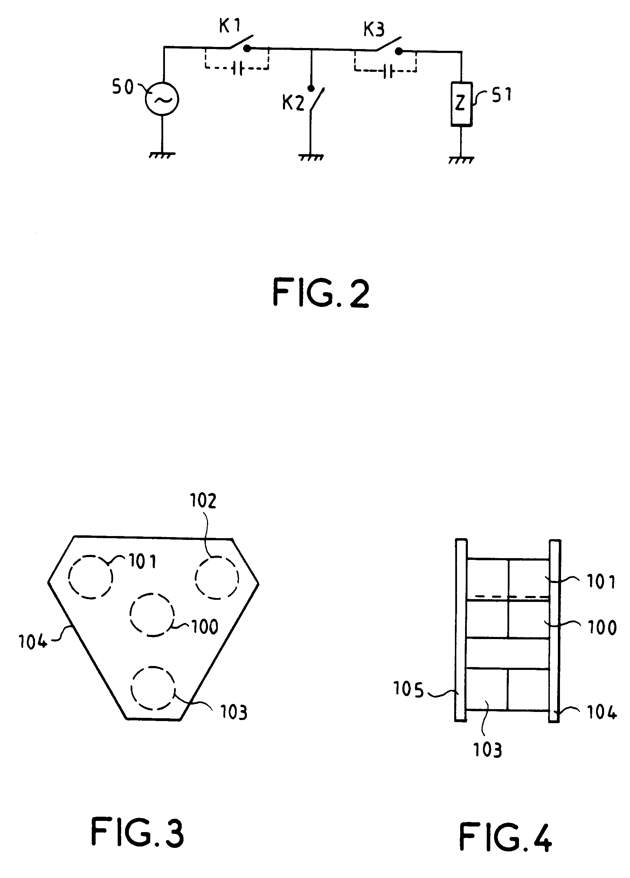

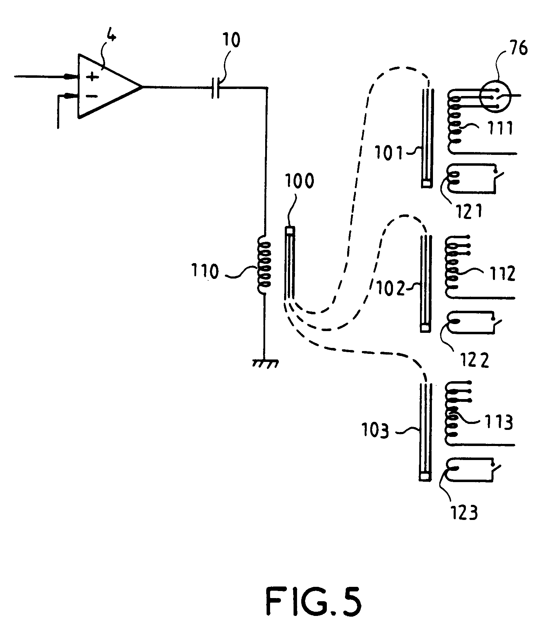

D'autres caractéristiques et avantages de l'invention ressortiront de la description ci-après d'un mode de réalisation donné à titre d'exemple, Cette description sera faite en regard du dessin dans lequel :
- une figure 1 représente le schéma électrique d'un circuit d'excitation des doubles enroulements d'une antenne triple d'émission d'un système électromagnétique de repérage renfermant un dispositif électronique de multiplexage selon l'invention pourvu de moyens de couplage par flux électromagnétique incorporant plusieurs transformateurs ;
- une figure 2 représente un schéma de principe d'un interrupteur en Té permettant de connecter ou de déconnecter une charge à une source tout en améliorant, par rapport à un simple interrupteur, l'isolement de la charge vis-à-vis de la source lorsqu'il est à l'état ouvert ;
- des figures 3 et 4 illustrant vu de dessus et vu par côté le circuit magnétique à plusieurs jambes parallèles d'un transformateur unique utilisable pour les moyens de couplage par flux électromagnétique ; et
- une figure 5 montrant les modifications du schéma électrique de la figure 1 qu'entraîne l'utilisation du transformateur unique dont le circuit magnétique est montré aux figures 3 et 4

On distingue sur la figure 1, les deux parties 1, 1', 2, 2' et 3, 3' des trois doubles enroulements d'une antenne triple d'émission d'un système électromagnétique de repérage, à faible distance, de la position et de l'orientation d'un objet. Ces doubles enroulements sont, comme indiqué précédemment, disposés dans des plans orthogonaux. Ils sont destinés d'une part à être excités successivement par un courant alternatif de même intensité d'une fréquence de l'ordre de la dizaine de kilohertz bien qu'ils ne présentent pas exactement la même impédance et d'autre part, lors qu'ils ne sont pas excités, à être parcourus par des courants résiduels aussi faibles que possible.

Le courant alternatif d'excitation est délivré séquentiellement aux doubles enroulements de l'antenne triple, par l'intermédiaire d'un multiplexeur selon l'invention, au moyen d'un amplificateur 4 équipé d'une boucle d'asservissement en courant commune aux trois doubles enroulements.

Les deux parties 1, 1', 2, 2'ou 3, 3'de chacun des trois doubles enroulements sont connectées en série et leur point d'interconnexion mis à la masse. Deux résistances 5, 5' de mesure de courant, de faible valeur, par exemple un Ohm, sont intercalées en série entre les deux parties De chacun des doubles enroulements, de part et d'autre de la masse. Elles délivrent, à l'entrée de la boucle d'asservissement en courant, ne tension alternative proportionnelle à l'intensité du courant alternatif d'excitation parcourant effectivement les doubles enroulements. L'amplificateur de mesure 6 de la boucle d'asservissement en courant amplifie cette tension de mesure et l'applique à l'amplificateur 4 qui la compare à une tension alternative de consigne d'entrée Ve et adapte l'amplitude de sa tension alternative de sortie pour annuler l'erreur entre tension de mesure et tension de consigne, et faire en sorte que le courant alternatif d'excitation garde une intensité constante dans les doubles enroulements.

Le multiplexeur interconnectant les trois doubles enroulements 1, 1', 2, 2' et 3, 3' à la sortie de l'amplificateur 4 comporte trois transformateurs 7, 8 et 9, autant que de doubles enroulements, pourvus chacun d'un enroulement primaire 71, 81, 91 à prises intermédiaires, d'un enroulement secondaire 72 à prises intermédiaires et d'un enroulement de mise en court-circuit 73.

Les trois enroulements primaires 71, 81, 91 des transformateurs 7, 8 et 9 sont connectés en série, par l'intermédiaire d'une capacité d'accord 10, entre la sortie de l'amplificateur 4 et la masse.

L'enroulement secondaire 72 du premier transformateur 7 est connecté aux bornes du premier double enroulement 1, 1' de l'antenne triple, tandis que l'enroulement secondaire du deuxième transformateur 8 est connecté aux bornes du deuxième double enroulement 2, 2' de l'antenne triple et que l'enroulement secondaire du troisième transformateur 9 est connecté aux bornes du troisième double enroulement 3, 3' de l'antenne triple.

Les trois enroulements auxiliaires de mise en court-circuit 73 des transformateurs 7, 8, 9 sont refermés par un premier banc de trois interrupteurs commandés par un circuit. de commande 40. Chacun de ces interrupteurs est formé de deux transistors à effet de champ 74, 75 interconnectés par leurs. électrodes source placées au potentiel de la masse. Les jonctions drain source de ces transistors à effet de champ 74, 75 sont mises en série et en opposition aux bornes de l'enroulement auxiliaire de mise en court-circuit afin de permettre le blocage des deux alternances de courant. Leurs électrodes grille sont connectées en parallèle et reçoivent du circuit de commande 40, une tension de commande de blocage ou de saturation C1, C2, C3. Cette tension de commande est une tension de polarisation grille source non flottante par rapport à la masse du fait que les transistors ont leur électrode source au potentiel de la masse ce qui est rendu possible par l'isolement de l'enroulement auxiliaire de mise en court-circuit par rapport aux autres enroulements primaire et secondaire de chaque transformateur.

Un deuxième banc de trois interrupteurs commandés permet d'ouvrir les circuits secondaires des trois transformateurs 7, 8, 9 pour diminuer les courants de fuite. Chaque interrupteur commandé de ce deuxième banc est formé de deux transistors à effet de champ 11, 12 ; 21, 22 ; 31, 32 intercalés en série entre les deux parties 1, 1' ; 2, 2' ; 3, 3' d'un double enroulement de l'antenne triple, de part et d'autre des résistances de mesure 5, 5'. Les électrodes source de ces transistors à effet de champ sont connectées à la masse par l'intermédiaire des résistances de mesure 5, 5' et se trouvent ainsi à un faible potentiel par rapport à la masse. Leurs jonctions drain source sont ainsi mises en série et en opposition dans le circuit secondaire d'un transformateur ce qui permet le blocage des deux alternances du courant. Leurs électrodes grilles sont connectées en parallèle et reçoivent du circuit de commande 40, une tension de commande de blocage ou de saturation. Comme les transistors à effet de champ 11, 12 ; 21, 22 ; 31, 33 ont leur électrode source à un potentiel proche de la masse, cette tension de commande est une tension de polarisation grille source non flottante par rapport à la masse qui prend, par commodité, les mêmes valeurs que la tension de commande des transistors du premier banc d'interrupteurs. Plus précisément, les tensions de commande des transistors à effets de champ 11, 12 ; 21, 22 ; 31, 32 de ce deuxième banc d'interrupteurs prennent des valeurs opposées C̅1̅, C̅2̅, C̅3̅ à celles appliquées aux transistors à effets champ du premier banc d'interrupteurs afin que les interrupteurs du deuxième banc prennent des états opposés à ceux du premier banc.

Il est envisageable, dans le cas où la boucle d'asservissement en courant n'est pas indispensable, de la supprimer et de remplacer les résistances de mesure 5, 5' par des ponts conducteurs. Les transistors à effet de champ des interrupteurs commandés du deuxième banc se trouvent alors être tous connectés par leur électrode source à la masse.

En fonctionnement normal, le circuit de commande 40 provoque le blocage, à tour de rôle, de l'un des trois interrupteurs du premier banc refermant les enroulements auxiliaires de mise en court-circuit des trois transformateurs 7, 8 et 9, la conduction des deux autres interrupteurs du premier banc et la mise dans des états de conduction opposés des interrupteurs du deuxième banc. Les deux transformateurs qui ont leur enroulement de mise en court-circuit refermé par un interrupteur du premier banc en conduction se saturent. Ils ramènent à leurs primaire et secondaire des impédances très faibles. Il en résulte que les doubles enroulements de l'antenne triple seraient pratiquement en court-circuit s'ils n'étaient ouverts par les interrupteurs correspondants du deuxième banc. De plus, il se produit à leur primaire une chute de tension négligeable reportant la majorité de la tension alternative d'excitation vue en sortie de l'amplificateur 4 par la capacité d'accord 10, aux bornes du primaire du troisième transformateur dont l'enroulement auxiliaire de mise en court-circuit est ouvert par un interrupteur bloqué. Comme, par ailleurs, ce troisième transformateur a son circuit secondaire refermé aux bornes d'un double enroulement de la triple antenne par l'intermédiaire d'un interrupteur du deuxième banc à l'état passant, il délivre à ce double enroulement un courant alternatif d'excitation qui garde une intensité constante sous l'action de la boucle d'asservissement en courant.

L'utilisation d'un enroulement primaire à prises intermédiaires pour chaque transformateur donne la possibilité d'une adaptation d'impédance. On peut ainsi, par un choix judicieux des prises par lesquelles sont attaqués les enroulements primaires des transformateurs, faire en sorte que les doubles enroulements, bien que d'impédances différentes, ramènent des impédances identiques aux primaires des transformateurs lorsque ces derniers ne sont pas saturés.

L'utilisation des deux bancs d'interrupteurs commandés pour, à la fois, court-circuiter les extrémités des doubles enroulements non excités de l'antenne triple et les ouvrir en un point milieu permet d'obtenir une bien meilleure annulation des courants qui les parcourent. En effet, les interrupteurs des deux bancs se comportent, pour chaque enroulement comme le montage d'interrupteurs en Té de la figure 2 qui présente, entre une source 50 d'énergie électrique alternative et une charge 51, deux interrupteurs en série K1 et K3 manoeuvrés en synchronisme et complétés par un troisième interrupteur K2 qui relie la masse à leur point milieu et qui est manoeuvré en opposition. Un tel montage permet, comme cela est bien connu, de réduire les effets des capacités parasites que présentent les transistors à effet de champ utilisés pour les interrupteurs car, lorsque la charge est isolée de la source par l'ouverture des interrupteurs K1, K3 et par la fermeture de l'interrupteur K2, il n'y a en amont de l'interrupteur K3 en série avec la charge qu'ne très faible portion de la tension de la source. L'interrupteur du premier banc qui est placé aux bornes de l'enroulement auxiliaire de mise en court-circuit d'un transformateur et commande la saturation de ce dernier joue le rôle des interrupteurs K1, K2 tandis que l'interrupteur du deuxième banc intercalé en série avec la charge joue le rôle de l'interrupteur K3.

L'utilisation de transformateurs entre la sortie de l'amplificateur 4 et les doubles enroulements 1, 1' ; 2, 2' ; 3, 3' de l'antenne triple permet d'obtenir un premier gain en tension en jouant sur le rapport entre enroulements primaire et secondaire. Ce premier gain en tension est complété par un deuxième gain en tension résultant de la mise en résonance de la charge inductive de l'amplificateur 4 au moyen du condensateur de liaison 10, ce complément étant fonction du coefficient de surtension du circuit oscillant obtenu qui peut atteindre quatre ou cinq.

Comme on peut le voir sur la figure 1, les prises intermédiaires de l'enroulement secondaire de chaque transformateur sont connectées à l'une des extrémités d'un double enroulement de l'antenne triple au moyen d'un sélecteur 76 qui permet de changer la fréquence d'accord de la charge de l'amplificateur 4 en changeant la self inductance vue a primaire du transformateur. Il peut en effet être utile, dans le cas considéré d'un système électromagnétique de repérage, à fable distance, de la position et de l'orientation d'un objet, de modifier la fréquence de fonctionnement pour se démarquer par rapport à un autre système électromagnétique de repérage fonctionnant dans le voisinage à la même fréquence.

Les trois transformateurs 7,8 et 9 utilisés dans le schéma de la figure 1 peuvent être remplacés par un unique transformateur avec un seul enroulement primaire ce qui permet de diminuer les pertes ohmiques dans le circuit primaire. Le transformateur unique présente alors un circuit magnétique à quatre jambes parallèles autour desquelles se répartissent les bobinages. Ce circuit magnétique peut-être réalisé, comme représenté aux figures 3 et 4 à l'aide de quatre piliers ou jambes 100, 101, 102, 103 de même longueur pris entre deux culasses planes 104, 105 de profil triangulaire. La jambe centrale 100 reçoit l'unique enroulement primaire tandis que chaque jambe périphérique 101, 102, 103, reçoit un enroulement secondaire et un enroulement auxiliaire de mise en court-circuit.

Le flux magnétique engendré par l'enroulement primaire dans la jambe centrale 100 du circuit magnétique se referme par les culasses 104 et 105 et par la seule jambe périphérique 101, 102 ou 103 qui n'a pas son enroulement auxiliaire en court-circuit de sorte que seul l'enroulement secondaire de cette jambe périphérique est couplé à l'enroulement primaire ce qui réalise la fonction multiplexage

Le schéma partiel de la figure 5 montre les modifications qui résultent pour le schéma de la figure 1 de l'emploi d'un unique transformateur avec un circuit magnétique à plusieurs jambes parallèles

La sortie de l'amplificateur 4 se trouve maintenant connectée par l'intermédiaire de la capacité d'accord 10 à l'nique enroulement primaire 110 bobiné sur la jambe centrale 100 du transformateur. Les enroulements secondaires 111, 112 respectivement 113 bobinés chacun sur une jambe périphérique 101, 102 respectivement 103 du transformateur avec un enroulement auxiliaire 121, 122 respectivement 123 sont raccordés, comme précédemment, aux extrémités des trois doubles enroulements de l'antenne triple par l'intermédiaire d'un sélecteur 76 permettant de changer la fréquence d'accord de la charge de l'amplificateur 4

La contrepartie liée à l'unicité du primaire est la nécessité d'employer des enroulements secondaires à nombres de spires différents pour l'équilibrage des impédances dans le cas où les charges présentent des impédances différentes. Dans ce but, on peut prévoir d'équiper les deux extrémités de chaque enroulement secondaire d'un jeu de prises intermédiaires l'un destiné au sélecteur permettant de changer la fréquence d'accord et l'autre destiné à l'équilibrage des impédances des différentes charges

On peut, sans sortir du cadre de l'invention modifier certaines dispositions ou remplacer certains moyens par des moyens équivalents. C'est ainsi, notamment, que dans le cas de la réalisation à plusieurs transformateurs distincts, un par charge, on peut, pour supprimer un couplage par flux magnétique non pas mettre un enroulement auxiliaire en court-circuit mats le faire traverser par un courant continu d'intensité suffisante pour saturer le chemin magnétique.

## Revendications

1. Dispositif électronique de multiplexage de charges (1,1' ; 2,2' ; 3,3') aux bornes d'une source (4) d'énergie électrique alternative caractérisé en ce qu'il comporte :
- des moyens de couplage par flux électromagnétique (7,8,9) de la source (4) d'énergie électrique alternative aux charges (1,1' ; 2,2' ; 3,3') comportant au moins un enroulement primaire d'excitation (71, 81, 91) connecté aux bornes de la source (4) d'énergie électrique alternative et des enroulements secondaires (72), en nombre égal à celui des charges (1,1' ; 2,2' ; 3,3'), couplés au moins partiellement à l'enroulement primaire (71, 81, 91) et connectés chacun aux bornes d'une charge (1,1' ; 2,2' ; 3,3') ;
- des moyens d'inhibition des moyens de couplage par flux électromagnétique (7,8,9) comportant des enroulements auxiliaires (73), en nombre égal à celui des charges (1,1' ; 2,2' ; 3,3'), chacun couplé totalement avec un enroulement secondaire (72) ; et
- des moyens de commande (40) des moyens d'inhibition imposant l'inhibition de tous les couplages magnétiques sauf un qui change en fonctions de la charge (1,1' ; 2,2' ; 3,3') à coupler à la source (4) d'énergie électrique alternative.

2. Dispositif selon la revendication 1, caractérisé en ce que les moyens de couplage par flux électromagnétique comportent autant d'enroulements primaires d'excitation (71, 81, 91) que de charges (1,1' ; 2,2' ; 3,3') connectés en série aux bornes de la source (4) d'énergie électrique alternative et couplés chacun totalement avec enroulement secondaire (72) et un enroulement auxiliaire (73) au sein d'un transformateur individuel (7,8,9)

3. Dispositif selon la revendication 1, caractérisé en ce que les moyens de couplage par flux électromagnétique comportent un unique enroulement primaire d'excitation (110) couplé partiellement aux différents enroulements secondaires (111, 112, 113) au sein d'un unique transformateur présentant un circuit magnétique à plusieurs jambes parallèles (100, 101, 102, 103) avec une première jambe (100) autour de laquelle est bobiné l'enroulement primaire d'excitation (110) et d'autres jambes (100, 102, 103) autour de chacune desquelles sont bobinés un enroulement secondaire (111, 112, 113) et un enroulement auxiliaire (121, 122, 123).

4. Dispositif selon la revendication 1, caractérisé en ce que les moyens d'inhibition comportent des moyens interrupteur de mise en court-circuit (74, 75) qui referment chacun l'un des enroulement auxiliaires (74) et qui sont commandés par les moyens de commande (40) qui impose un état ouvert à l'un d'entre eux et un état fermé à tous les autres, le premier moyen interrupteur de mise en court-circuit à l'état ouvert changeant en fonction de la charge (1,1' ; 2,2' ; 3,3') à coupler à la source (4) d'énergie électrique alternative.

5. Dispositif selon la revendications 2, caractérisé en ce que les moyens d'inhibition comportent des sources commandables de courant électrique continu qui injectent chacune, un courant électrique continu dans un des enroulements auxiliaires entraînant une saturation du flux magnétique dans l'enroulement secondaire lui correspondant par couplage, et qui sont commandés par les moyens de commande qui ne bloquent que l'une d'entre elles choisie en fonction de la charge (1,1' ; 2,2' ; 3,3') à coupler à la source (4) d'énergie électrique alternative.

6. Dispositif selon la revendication 1, caractérisé en ce qu'il comporte en outre des moyens interrupteur d'isolement (11, 12 ; 21, 22 ; 31, 32) en nombre égal aux charges (1,1' ; 2,2' ; 3,3') intercalés chacun en série entre une charge et l'enroulement secondaire auquel elle est connectée, lesdits moyens de commande (40) imposant un état fermé au moyen interrupteur d'isolement disposé en série avec la charge dont le moyen du couplage par flux électromagnétique avec la source (4) d'énergie électrique alternative n'est pas inhibé et un état ouvert à tous les autres moyens interrupteurs d'isolement.

7. Dispositif selon la revendication 1, interconnecté avec des charges inductives (1, 1' ; 2, 2'; 3, 3') accordées à l'aide d'un condensateur (10) disposé en série avec la source d'énergie électrique alternative, caractérisé en ce que les enroulements secondaires (72) comportent des prises de réglage reliées à un sélecteur (76) permettant de faire varier la fréquence d'accord.

8. Dispositif selon la revendication 2, interconnecté avec des charges d'impédances différentes, caractérisé en ce que les enroulements primaires (71, 81, 91) des transformateurs (7, 8, 9) comportent des prises intermédiaires de réglage dont l'utilisation permet une égalisation des impédances présentées par les charges à la source d'énergie électrique alternative.

9. Dispositif selon la revendication 4, caractérisé en ce que chaque moyen interrupteur de mise en court-circuit comporte deux transistors à effet de champ (74, 75) interconnectés par leur électrode source mise à la masse avec leurs jonctions drain source mises en série et en opposition aux bornes d'un enroulement auxiliaire et leurs électrodes grille connectée en parallèle et polarisées par les moyens de commande (40).

10. Dispositif selon la revendication 6, interconnecté entre des charges (1, 1' ; 2, 2' ; 3, 3') à point milieu mis à la masse, caractérisé en ce que chaque moyen interrupteur l'isolement comporte deux interrupteurs intercalés en série dans une charge (1, 1'; 2, 2'; 3, 3') de part et d'autre du point milieu.

11. Dispositif selon la revendication 6, interconnecté entre des charges (1, 1' ; 2, 2' ; 3, 3') à point milieu mis à la masse et une source d'énergie électrique alternative pourvue d'une boucle d'asservissement en courant mesurant le courant circulant dans les charges (1, 1' ; 2, 2' ; 3, 3') à partir de la tension développée aux bornes de deux résistances de mesure (5, 5') intercalées de part et d'autre du point milieu de mise à la masse, caractérisé en ce que chaque moyen interrupteur d'isolement comporte deux interrupteurs intercalés en série dans une charge (1, 1' ; 2, 2' ; 3, 3') de part et d'autre des résistances de mesure (5, 5').

12. Dispositif selon la revendication 10, caractérisé en ce que chaque moyen interrupteur d'isolement comporte deux transistors à effet de champ (11, 12 ; 21, 22 ; 31, 32) intercalés dans une charge (1, 1' ; 2, 2' ; 3, 3') de part et d'autre de son point milieu mis à la masse, avec leurs électrodes source interconnectées audit point milieu, leurs jonctions drain source mises en série et en opposition interconnectant les deux parties d'une charge et leurs électrodes grille connectées en parallèle et polarisées par les moyens de commande (40).

13. Dispositif selon la revendication 11, caractérisé en ce que chaque moyen interrupteur d'isolement comporte deux transistors à effet de champ (11, 12 ; 21, 22 ; 31, 32) intercalés dans une charge (1, 1' ; 2, 2' ; 3, 3') de part et d'autre des résistances de mesure (5, 5'), avec leurs électrodes source interconnectées aux résistances de mesure (5, 5'), leurs jonctions drain source en série et en opposition interconnectant les deux parties d'une charge aux résistances de mesure (5, 5'), et leurs électrodes grille connectées en parallèle et polarisées par les moyens de commande (40).

## Claims

1. Electronic device for multiplexing loads (1, 1'; 2, 2'; 3, 3') to the terminals of a source (4) of alternating electrical energy, characterized in that it includes:
- means (7, 8, 9) for coupling the source (4) of alternating electrical energy by electromagnetic flux to the loads (1, 1'; 2, 2'; 3, 3') including at least one primary excitation winding (71, 81, 91) connected to the terminals of the source (4) of alternating electrical energy, and secondary windings (72), equal in number to that of the loads (1, 1'; 2, 2'; 3, 3'), at least partially coupled to the primary winding (71, 81, 91) and each connected to the terminals of a load (1, 1'; 2, 2'; 3, 3');
- means of inhibiting the means (7, 8, 9) of coupling by electromagnetic flux including auxiliary windings (73), equal in number to that of the loads (1, 1'; 2, 2'; 3, 3'), each totally coupled with a secondary winding (72); and
- means (40) for control of the inhibition means imposing the inhibition of all the magnetic couplings except one, which changes depending on the load (1, 1'; 2, 2'; 3, 3') to be coupled to the source (4) of alternating electrical energy.

2. Device according to Claim 1, characterized in that the means of coupling by electromagnetic flux includes as many primary excitation windings (71, 81, 91) as loads (1, 1'; 2, 2'; 3, 3') connected in series to the terminals of the source (4) of alternating electrical energy and each totally coupled with a secondary winding (72) and an auxiliary winding (73) within an individual transformer (7, 8, 9).

3. Device according to Claim 1, characterized in that the means of coupling by electromagnetic flux include a single primary excitation winding (110) partially coupled to the various secondary windings (111, 112, 113) within a single transformer having a magnetic circuit with several parallel legs (100, 101, 102, 103) with a first leg (100) around which is wound the primary excitation winding (110) and other legs (100, 102, 103) around each of which are wound a secondary winding (111, 112, 113) and an auxiliary winding (121, 122, 123).

4. Device according to Claim 1, characterized in that the inhibition means include short-circuiting switch means (74, 75) which each close one of the auxiliary windings (74) and which are controlled by the control means (40) which impose an open state on one of them and a closed state on all the others, the first short-circuiting switch means in the open state changing depending on the load (1, 1'; 2, 2'; 3, 3') to be coupled to the source (4) of alternating electrical energy.

5. Device according to Claim 2, characterized in that the inhibition means include controllable sources of direct electrical current which each inject a direct electrical current into one of the auxiliary windings bringing about a saturation of the magnetic flux in the secondary winding corresponding to it by coupling, and which are controlled by the control means which block only one of them chosen on the basis of the load (1, 1'; 2, 2'; 3, 3') to be coupled to the source (4) of alternating electrical energy.

6. Device according to Claim 1, characterized in that it further includes isolating switch means (11, 12; 21, 22; 31, 32) equal in number to the loads (1, 1'; 2, 2'; 3, 3') each interposed in series between a load and the secondary winding to which it is connected, the said control means (40) imposing a closed state on the isolating switch means arranged in series with the load whose means of coupling by electromagnetic flux with the source (4) of alternating electrical energy is not inhibited and an open state on all the other isolating switch means.

7. Device according to Claim 1, interconnected with inductive loads (1, 1'; 2, 2'; 3, 3') tuned with the aid of a capacitor (10) arranged in series with the source of alternating electrical energy, characterized in that the secondary windings (72) include adjustment tappings linked to a selector (76) allowing the tuning frequency to be varied.

8. Device according to Claim 2, interconnected with loads of different impedances, characterized in that the primary windings (71, 81, 91) of the transformers (7, 8, 9) include intermediate adjustment tappings the use of which allows equalization of the impedances presented by the loads to the source of alternating electrical energy.

9. Device according to Claim 4, characterized in that each short-circuiting switch means includes two field-effect transistors (74, 75) interconnected by their source electrode taken to earth with their drain-source junctions placed in series and in opposition at the terminals of an auxiliary winding and their gate electrodes connected in parallel and biased by the control means (40).

10. Device according to Claim 6, interconnected between loads (1, 1'; 2, 2'; 3, 3') with mid point taken to earth, characterized in that each isolating switch means includes two switches interposed in series in a load (1, 1'; 2, 2'; 3, 3') on either side of the mid point.

11. Device according to Claim 6, interconnected between loads (1, 1'; 2, 2'; 3, 3') with mid point taken to earth and a source of alternating electrical energy provided with a current slaving loop measuring the current flowing in the loads (1, 1'; 2, 2'; 3, 3') on the basis of the voltage developed at the terminals of two measurement resistors (5, 5') interposed on either side of the earthing mid point, characterized in that each isolating switch means includes two switches interposed in series in a load (1, 1'; 2, 2'; 3, 3') on either side of the measurement resistors (5, 5').

12. Device according to Claim 10, characterized in that each isolating switch means includes two field-effect transistors (11, 12; 21, 22; 31, 32) interposed in a load (1, 1'; 2, 2'; 3, 3') on either side of its earthed mid point, with their source electrodes interconnected to the said mid point, their drain-source junctions placed in series and in opposition interconnecting the two parts of a load and their gate electrodes connected in parallel and biased by the control means (40).

13. Device according to Claim 11, characterized in that each isolating switch means includes two field-effect transistors (11, 12; 21, 22; 31, 32) interposed in a load (1, 1'; 2, 2'; 3, 3') on either side of the measurement resistors (5, 5'), with their source electrodes interconnected to the measurement resistors (5, 5'), their drain-source junctions in series and in opposition interconnecting the two parts of a load to the measurement resistors (5, 5'), and their gate electrodes connected in parallel and biased by the control means (40).

## Patentansprüche

1. Elektronische Anordnung zum Multiplexieren von Lasten (1, 1'; 2, 2'; 3, 3') an den Klemmen einer Quelle (4) elektrischer Wechselenergie, dadurch gekennzeichnet, daß sie enthält:
- durch elektromagnetischen Fluß wirkende Kopplungsmittel (7, 8, 9) zur Kopplung der Quelle (4) elektrischer Wechselenergie mit den Lasten (1, 1'; 2, 2'; 3, 3'), die wenigstens eine an die Klemmen der Quelle (4) elektrischer Wechselenergie angeschlossene Erregungs-Primärwicklung (71, 81, 91) und Sekundärwicklungen (72) enthält, deren Anzahl gleich derjenigen der Lasten (1, 1'; 2, 2'; 3, 3') ist und die wenigstens teilweise mit der Primärwicklung (71, 81, 91) gekoppelt und jeweils mit den Klemmen einer Last (1, 1'; 2, 2'; 3, 3') verbunden sind;
- Sperrmittel zur Sperrung der durch elektromagnetischen Fluß wirkenden Kopplungsmittel (7, 8, 9), die Hilfswicklungen (73) enthalten, deren Anzahl gleich derjenigen der Lasten (1, 1'; 2, 2'; 3, 3') ist und von denen jede mit einer Sekundärwicklung (72) total gekoppelt ist; und
- Steuermittel (40) zur Steuerung der Sperrmittel, welche die Sperrung aller magnetischen Kopplungen veranlassen, ausgenommen eine, die sich in Abhängigkeit von der mit der Quelle (4) elektrischer Wechselenergie zu koppelnden Last ändert.

2. Anordnung nach Anspruch 1, dadurch gekennzeichnet, daß die durch elektromagnetischen Fluß wirkenden Kopplungsmittel ebensoviele Erregungs-Primärwicklungen (71, 81, 91) enthalten wie Lasten (1, 1'; 2, 2'; 3, 3') in Serie an die Klemmen der Quelle (4) elektrischer Wechselenergie angeschlossen sind, und von denen jede mit einer Sekundärwicklung (72) und einer Hilfswicklung (73) innerhalb eines individuellen Transformators (7, 8, 9) total gekoppelt ist.

3. Anordnung nach Anspruch 1, dadurch gekennzeichnet, daß die durch elektromagnetischen Fluß wirkenden Kopplungsmittel eine einzige Erregungs-Primärwicklung (110) enthalten, die mit den verschiedenen Sekundärwicklungen (111, 112, 113) innerhalb eines einzigen Transformators teilweise gekoppelt ist, der einen Magnetkreis mit mehreren parallelen Schenkeln (100, 101, 102, 103) aufweist, mit einem ersten Schenkel (100), um den die Primärwicklung (110) gewickelt ist, und mit weiteren Schenkeln (100, 102, 103), um die jeweils eine Sekundärwicklung (111, 112, 113) und eine Hilfswicklung (121, 122, 123) gewickelt sind.

4. Anordnung nach Anspruch 1, dadurch gekennzeichnet, daß die Sperrmittel Kurzschlußschaltmittel (74, 75) enthalten, die jeweils eine der Hilfswicklungen (74) schließen und die durch die Steuermittel (40) gesteuert sind, die einem von ihnen einen offenen Zustand und allen anderen einen geschlossenen Zustand auferlegen, wobei sich das erste, im offenen Zustand befindliche Kurzschlußschaltmittel in Abhängigkeit von der mit der Quelle (4) elektrischer Wechselenergie zu koppelnden Last (1, 1'; 2, 2'; 3, 3') ändert.

5. Anordnung nach Anspruch 2, dadurch gekennzeichnet, daß die Sperrmittel steuerbare elektrische Gleichstromquellen enthalten, von denen jede in eine der Hilfswicklungen einen elektrischen Gleichstrom einspeist, der eine Sättigung des Magnetflusses in der ihr durch Kopplung entsprechenden Sekundärwicklung ergibt, und die durch die Steuermittel gesteuert werden, die nur eine von ihnen blockieren, die in Abhängigkeit von der mit der Quelle (4) elektrischer Wechselenergie zu koppelnden Last (1, 1'; 2, 2'; 3, 3') gewählt wird.

6. Anordnung nach Anspruch 1, dadurch gekennzeichnet, daß sie ferner Trennschaltmittel (11, 12; 21, 22; 31, 32) enthält, deren Anzahl gleich derjenigen der Lasten (1, 1'; 2, 2'; 3, 3') ist und die jeweils in Serie zwischen einer Last und der mit ihr verbundenen Sekundärwicklung eingefügt ist, wobei die Steuermittel (40) dem Trennschaltmittel, das in Serie mit der Last angeordnet ist, deren durch elektromagnetischen Fluß wirkendes Kopplungsmittel zur Kopplung mit der Quelle (4) elektrischer Wechselenergie nicht gesperrt ist, einen geschlossenen Zustand und allen anderen Trennschaltmitteln in einen offenen Zustand auferlegt.

7. Anordnung nach Anspruch 1, die mit induktiven Lasten (1, 1'; 2, 2'; 3, 3') verbunden ist, die mit Hilfe eines in Serie mit der Quelle elektrischer Wechselenergie angeordneten Kondensators (10) abgestimmt sind, dadurch gekennzeichnet, daß die Sekundärwicklungen (72) Anzapfungen aufweisen, die mit einem Wähler (76) verbunden sind, der die Änderung der Abstimmfrequenz ermöglicht.

8. Anordnung nach Anspruch 2, die mit Lasten unterschiedlicher Impedanzen verbunden ist, dadurch gekennzeichnet, daß die Primärwicklungen (71, 81, 91) der Transformatoren (7, 8, 9) Zwischenanzapfungen aufweisen, eine Angleichung der Impedanzen ermöglicht, die die Lasten für die Quelle elektrischer Wechselenergie darstellen.

9. Anordnung nach Anspruch 4, dadurch gekennzeichnet, daß jedes Kurzschlußschaltmittel zwei Feldeffekttransistoren (74, 75) enthält, die an ihren an Masse liegenden Source-Elektroden miteinander verbunden sind, wobei ihre Drain-Source-Verbindungen in Serie geschaltet und gegensinnig mit den Klemmen einer Hilfswicklung verbunden sind und ihre Gate-Elektroden parallelgeschaltet und durch die Steuermittel (40) vorgespannt sind.

10. Anordnung nach Anspruch 6, die zwischen Lasten (1, 1'; 2, 2'; 3, 3') mit an Masse liegender Mittelanzapfung angeschlossen ist, dadurch gekennzeichnet, daß jedes Trennschaltmittel zwei Schalter enthält, die in Serie in eine Last (1, 1'; 2, 2'; 3, 3') zu beiden Seiten der Mittelanzapfung eingefügt sind.

11. Anordnung nach Anspruch 6, die zwischen Lasten (1, 1'; 2, 2'; 3, 3') mit an Masse liegender Mittelanzapfung und einer Quelle elektrischer Wechselenergie angeschlossen ist, die mit einer Stromregelschleife ausgestattet ist, die den in den Lasten (1, 1'; 2, 2'; 3, 3') fließenden Strom aufgrund der Spannung mißt, die an den Klemmen von zwei Meßwiderständen (5, 5') entsteht, die zu beiden Seiten der Masseanschluß-Mittelanzapfung eingefügt sind, dadurch gekennzeichnet, daß jedes Trennschaltmittel zwei Schalter enthält, die in Serie in eine Last (1, 1'; 2, 2'; 3, 3') zu beiden Seiten der Meßwiderstände (5, 5') eingefügt sind.

12. Anordnung nach Anspruch 10, dadurch gekennzeichnet, daß jedes Trennschaltmittel zwei Feldeffekttransistoren (11, 12; 21, 22; 31, 32) enthält, die in eine Last (1, 1'; 2, 2'; 3, 3') zu beiden Seiten ihrer an Masse liegenden Mittelanzapfung eingefügt sind, wobei ihre Source-Elektroden mit der Mittelanzapfung verbunden sind, ihre Drain-Source-Verbindungen in Serie geschaltet sind und die beiden Teile einer Last gegensinnig miteinander verbinden, und wobei ihre Gate-Elektroden parallelgeschaltet und durch die Steuermittel (40) vorgespannt sind.

13. Anordnung nach Anspruch 11, dadurch gekennzeichnet, daß jedes Trennschaltmittel zwei Feldeffekttransistoren (11, 12; 21, 22; 31, 32) enthält, die in eine Last (1, 1'; 2, 2'; 3, 3') zu beiden Seiten der Meßwiderstände (5, 5') eingefügt sind, wobei ihre Source-Elektroden mit den Meßwiderständen (5, 5') verbunden sind, ihre Drain-Source-Verbindungen in Serie geschaltet sind und die beiden Teile einer Last gegensinnig mit den Meßwiderständen (5, 5') verbinden, und ihre Gate-Elektroden parallelgeschaltet und durch die Steuermittel (40) vorgespannt sind.
